# EUROPEAN PATENT SPECIFICATION

(11) **EP 2 657 990 B1**
(45) Date of publication and mention of the grant of the patent: **23.03.2016**
(21) Application number: 10861213.6
(22) Date of filing: 20.12.2010
(51) Int. Cl.: C09K 11/78, H01J 29/28, H01J 63/04, H01J 63/06, H01J 31/12, H01J 29/20

(54) **LIGHT EMITTING DEVICE AND MANUFACTURING METHOD THEREOF**
LICHTEMITTIERENDE VORRICHTUNG UND HERSTELLUNGSVERFAHREN DAFÜR
ÉMETTEUR DE LUMIÈRE ET SON PROCÉDÉ DE FABRICATION

(43) Date of publication of application: 30.10.2013
(73) Proprietor: OCEAN'S KING LIGHTING SCIENCE & TECHNOLOGY CO., LTD., Guangdong 518054 (CN)
(72) Inventor: ZHOU, Mingjie, Shenzhen Guangdong 518054 (CN); MA, Wenbo, Shenzhen Guangdong 518054 (CN); LIU, Yugang, Shenzhen Guangdong 518054 (CN)
(74) Representative: Grosse, Rainer
(86) International application number: PCT/CN2010/080032
(87) International publication number: WO 2012/083520

(56) References cited:
- EP-A1- 2 620 972
- CN-A- 101 728 151
- CN-U- 201 576 698
- US-A- 4 340 839
- US-A1- 2004 101 617
- US-A1- 2010 187 976

## Description

### TECHNICAL FIELD

The present invention relates to the technical field of luminescent materials, and particularly to a luminescent device. The present invention also relates to a method for manufacturing a luminescent device.

### BACKGROUND ART

Conventional materials used as the luminescent substrate include fluorescent powder, nano-crystal, luminescent glass, transparent ceramic, and the like. Transparent ceramic has distinctive advantages over other luminescent materials. Compared with luminescent glass, transparent ceramic has higher luminescent efficiency. Compared with fluorescent powder and nano-crystal, transparent ceramic has characteristics of transparency, high mechanical strength, good chemical stability, etc., and is easier to be processed into products with various sizes and shapes, such as displays or illumination lighting sources with various sizes or shapes.

For example, in the field of vacuum microelectronics, luminescent ceramic is usually used as phosphor in a field emission device. Luminescent ceramic exhibits a broad application prospect in the aspects of illumination and displaying, and has attracted extensive attention from research institutes worldwide. The operation mechanism of a field emission device comprises the followings: an anode applies a forward voltage against field emissive arrays (FEAs) in vacuum to establish an accelerating electric field, in which the electrons emitted by the cathode are accelerated and bombard the luminescent material on the anode plate, leading to light emission. The field emission device has broad operation temperature range (-40°C to 80°C), short response time (<1 ms), simple structure, low power consumption, and meets the need of environmental protection.

However, when used as a luminescent material in a field emission device, transparent ceramic has a problem with regard to low luminescent efficiency.

EP 2 620 972 A1, filed on September 26, 2010 and published on July 31, 2013, discloses a field emission anode plate, a field emission light source and a manufacturing method for the light source.

US 2010/187976 A1 discloses a ceramic phosphor element which is used as conversion phosphor in LEDs.

US 2004/101617 A1 discloses a method of forming luminescent films or coatings from a liquid precursor mixture utilizing a RF-induced plasma spraying process.

US 4 340 839 A discloses a method for making highly densed zinc sulfide ceramic materials in the form of the sintered material.

### DISCLOSURE OF THE INVENTION

To address the above problems, the present invention provides a luminescent device comprising transparent ceramic having a formula of Y₂O₃:Eu as a luminescent substrate.

The luminescent device comprises a luminescent substrate, and a metal layer which is disposed on the surface of the luminescent substrate and has a metal microstructure which is composed of irregularly arranged metal nano-particles; the material for the luminescent substrate being transparent ceramic having a formula of Y₂O₃: Eu.

In the luminescent device, the material for the metal layer is at least one selected from the group consisting of gold, silver, aluminum, copper, titanium, iron, nickel, cobalt, chromium, platinum, palladium, magnesium and zinc, and the thickness of the metal layer may be in the range of 0.5 nm to 200 nm.

Another object of the present invention is to provide a method for manufacturing the luminescent device as described above, comprising the steps of:
Step S1: washing and drying a luminescent substrate, wherein the material for the luminescent substrate is transparent ceramic having a formula of Y₂O₃:Eu;
Step S2: disposing a metal layer on a surface of the luminescent substrate;
Step S3: annealing the luminescent substrate disposed with the metal layer in vacuum and then cooling, to produce a luminescent device having the metal layer with a metal microstructure which is composed of irregularly arranged metal nano-particles.

In step S2 of the above manufacturing method, the material for the metal layer is at least one selected from the group consisting of gold, silver, aluminum, copper, titanium, iron, nickel, cobalt, chromium, platinum, palladium, magnesium and zinc, and the thickness of the metal layer may be in the range of 0.5 nm to 200 nm.

In step S3 of the above manufacturing method, the annealing process comprises: annealing at 50°C to 650°C in vacuum for 0.5 to 5 hours, and then naturally cooling to room temperature.

Compared with the prior art, the present invention has the following advantages:
1. In the luminescent device according to the present invention, by disposing a metal layer having a metal microstructure on the luminescent substrate, surface plasmon is produced at the interface between the luminescent substrate and the metal layer disposed thereon under cathode ray. Due to the surface plasmon effect, the internal quantum efficiency of the luminescent substrate is significantly increased, i.e. the spontaneous emission of transparent ceramic is enhanced, and accordingly the luminescent efficiency of the luminescent substrate is greatly improved.
2. In the method for manufacturing the luminescent device of the present invention, the luminescent device is produced simply by disposing a metal layer on the luminescent substrate and annealing to give a metal microstructure; therefore, the manufacturing process is simple with low costs.

### BRIEF DESCRIPTION OF THE DRAWINGS

Fig. 1 is a schematic diagram showing the structure of the luminescent device according to the present invention;
Fig. 2 is a flow chart of the method for manufacturing the luminescent device according to the present invention;
Fig. 3 is a schematic diagram showing the light emission process of the luminescent device according to the present invention;
Fig. 4 shows a comparison of the luminescent spectra of the luminescent device produced according to Example 1 and the transparent ceramic without a metal layer, wherein the test condition of the cathode ray luminescent spectra is: an accelerating voltage of 10KV is applied on the excited electron beam.

### DETAILED DESCRIPTION OF THE EMBODIMENTS

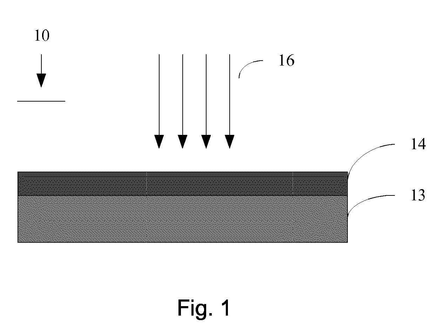

The present invention provides a luminescent device 10 as shown in Fig. 1, comprising a luminescent substrate 13 and a metal layer 14 which is disposed on a surface of the luminescent substrate 13 and has a metal microstructure. The metal microstructure is non-periodic, i.e. composed of irregularly arranged metal nano-particles. The luminescent substrate 13 is a Eu-doped Y₂O₃ series luminescent transparent ceramic, i.e. luminescent ceramic, which is typically a Eu-doped Y₂O₃ series transparent ceramic having a formula of Y₂O₃:Eu.

In the luminescent device 10, the material for the metal layer 14 may be formed from a metal with good chemical stability, for example at least one metal selected from gold, silver, aluminum, copper, titanium, iron, nickel, cobalt, chromium, platinum, palladium, magnesium and zinc, preferably at least one metal selected from gold, silver and aluminum. The metal species in the metal layer 14 may be a single metal or a composite metal. The composite metal may be an alloy of two or more of the above metals. For example, the metal layer 14 may be a sliver-aluminum alloy layer or a gold-aluminum alloy layer, in which silver or gold preferably represents 70% or above by weight. The thickness of the metal layer 14 is in the range of 0.5 nm to 200 nm, preferably 1 nm to 100 nm.

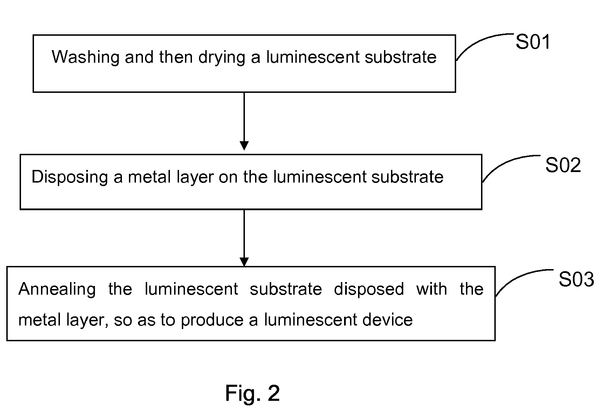

The present invention also provides a method for manufacturing the luminescent device described above, as shown in Fig. 2, comprising the following steps:
S01: washing the luminescent substrate sequentially with acetone, deionized water and absolute alcohol, followed by oven-drying or blast-drying;
S02: disposing a metal layer on a surface of the luminescent substrate;
S03: annealing the luminescent substrate disposed with the metal layer in vacuum and then cooling, to produce a luminescent device having the metal layer with a metal microstructure.

In step S01 of the above method, the luminescent substrate may be a Eu-doped Y₂O₃ series transparent luminescent ceramic having a formula of Y₂O₃:Eu. In practice, transparent ceramic is processed into various forms required by the applications by means of machining, polishing, and the like, to form the luminescent substrate.

The metal layer may be formed by depositing a source of a metal material having good chemical stability, for example a metal resistant to oxidative corrosion, or a common metal material, preferably at least one metal selected from gold, silver, aluminum, copper, titanium, iron, nickel, cobalt, chromium, platinum, palladium, magnesium and zinc, more preferably at least one metal selected from gold, silver and aluminum.

In step S02 of the above method, the metal layer is formed on a surface of the luminescent substrate by physical or chemical vapor deposition of at least one metal as described above, for example but not limited to the method of sputtering or evaporating. The thickness of the metal layer is in the range of 0.5 nm to 200 nm, preferably 1 nm to 100 nm.

Step S03 of the above method specifically comprises: forming a metal layer on a surface of the luminescent substrate, annealing at 50°C to 650°C in vacuum for 1 to 5 hours, and naturally cooling to room temperature, wherein the annealing temperature is preferably 100°C to 500°C and the annealing time is preferably 1 to 3 hours.

As shown in Fig. 1, the luminescent device 10 described above may be widely used in luminescent devices with ultra-high brightness and high operation speed, for example, field emission display, field emission light resource, large advertising display board, and the like. For example, in a field emission display, an anode applies a forward voltage against field emissive arrays to establish an accelerating electric field, and accordingly the cathode emits electrons, i.e. emitting cathode rays 16 towards the metal layer 14, so that surface plasmon is produced at the interface between the metal layer 14 having a metal microstructure and the luminescent substrate 13. Due to the surface plasmon effect, the internal quantum efficiency of the luminescent substrate 13 is significantly increased; in other words, the spontaneous radiation of transparent ceramic is enhanced. This further greatly improves the luminescent efficiency of the luminescent substrate, and solves the problem with regard to low luminescent efficiency of the luminescent material. In addition, since a metal layer is formed on a surface of the luminescent substrate 13 and a uniform interface is formed between the whole metal layer and the luminescent substrate 13, the uniformity of light emitting may be improved.

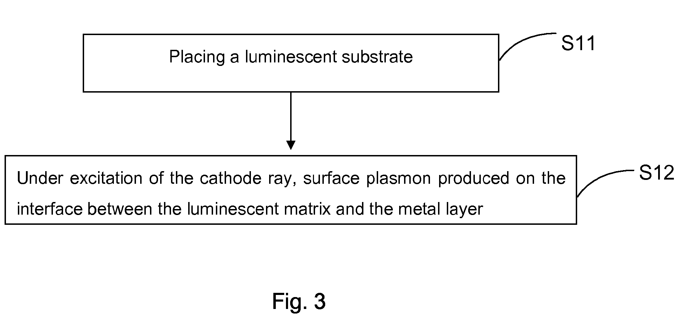

In practice, the light emitting process of the luminescent device according to the present invention, as shown in Fig. 3, comprises:
- S11:: placing the surface of the luminescent device on which the metal layer is disposed straight ahead of the cathode ray radiation;
- S12:: emitting cathode rays to the metal layer, so that surface plasmon is produced between the metal layer and the luminescent substrate under the excitation of the cathode rays, which enhances the luminescent intensity of the luminescent substrate.

In practice, step S12 may be carried out by using a field emission display or a lighting source. In a vacuum environment, the anode applies a forward voltage against field emissive arrays to establish an accelerating electric field, and accordingly the cathode emits cathode rays. Under excitation of cathode rays, an electron beam first passes through the metal layer and then excites the luminescent substrate to emit light. In this process, the surface plasmon effect is produced at the interface between the metal layer and the luminescent substrate, which lead to significant increase of the internal quantum efficiency of the luminescent substrate, i.e. enhancing the spontaneous radiation of the luminescent material, and great improvement of the luminescent efficiency of the luminescent material.

As described above, an electron beam passes through the metal layer and then excites the luminescent substrate to emit light, wherein surface plasmon is produced at the interface between the luminescent substrate and the metal layer, so that the light emission of ceramic Y₂O₃:Eu is promoted.

Surface Plasmon (SP) is a wave propagating along the interface between a metal and a medium, and the amplitude thereof exponentially decays with the distance from the interface. When the structure of the metal surface is changed, the properties, dispersion relationship, excitation mechanism, coupling effect, etc., of surface plasmon polaritons (SPPs) would significantly vary. The electromagnetic field induced by SPPs can not only limit the wave propagation in a sub-wavelength structure, but also produce and control electromagnetic radiations ranging from optical frequency to microwave band, so as to achieve active control on the light propagation. Therefore, the present embodiment employs the excitation property of SPPs to enhance the optical state density and the spontaneous radiation rate of the luminescent substrate. Moreover, the coupling effect of surface plasmon may be utilized; when the luminescent substrate emits light, a coupling resonance effect may occur between surface plasmon and the luminescent substrate, which leads to significant increase in the inner quantum efficiency of the luminescent substrate and improvement in the emission efficiency of the luminescent substrate.

Preferred examples of the present invention will be described in more details with reference to the drawings.

### Example 1

A Eu-doped Y₂O₃ series transparent ceramic plate, i.e. a luminescent ceramic having a formula of Y₂O₃:Eu, is used as the luminescent substrate. A silver layer having a thickness of 20 nm is deposited on a surface of the transparent ceramic plate with a megnetron sputtering equipment. The resulted device is placed in a vacuum environment have a vacuity of <1×10⁻³ Pa, annealed at 300°C for half an hour, and then cooled to room temperature, to give a luminescent device with a metal layer having a metal microstructure.

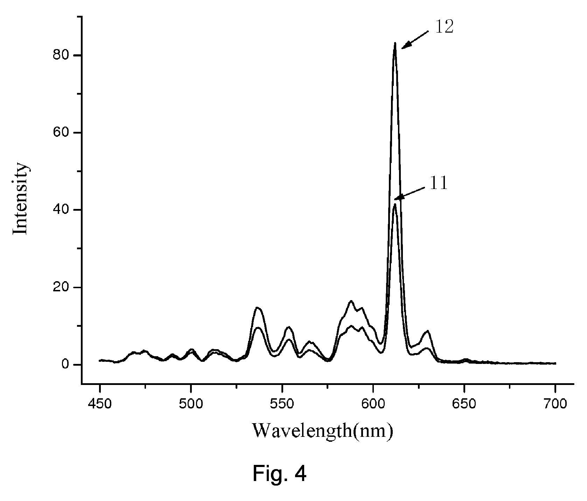

A spectral test is carried out on the luminescent device manufactured above, wherein the luminescent device is bombarded by cathode rays produced by an electron gun. An electron beam first passes through the metal layer and then excites transparent ceramic Y₂O₃:Eu to emit light, yielding a luminescent spectrum as shown in Fig. 4. The spectrum in the figure shows that the luminescent material is a green-light-emitting luminescent material. Curve 11 in the figure represents the luminescent spectrum of a luminescent ceramic without a silver layer, and curve 12 represents the luminescent spectrum of the luminescent device with the metal layer produced according to this example. As can be seen from the figure, due to the surface plasmon effect occurred at the interface between the metal layer and the transparent ceramic, the integral luminescent intensity of the transparent ceramic with the metal layer according to the present example from 450 nm to 700 nm was 1.8 times of that of the transparent ceramic without metal layer. Therefore, the luminescent property is significantly improved.

### Example 2

Example 2 is basically the same as Example 1, excepted that a gold layer having a thickness of 200 nm is deposited on a surface of the luminescent substrate, the resulted device is placed in a vacuum environment have a vacuity of <1×10⁻³ Pa, annealed at 650°C for 1 hour, and then cooled to room temperature, to give a luminescent device with a metal layer having a metal microstructure.

### Example 3

Example 3 is basically the same as Example 1, excepted that an aluminum layer having a thickness of 0.5 nm is deposited on a surface of the luminescent substrate, the resulted device is placed in a vacuum environment have a vacuity of <1×10⁻³ Pa, annealed at 50°C for 5 hours, and then cooled to room temperature, to give a luminescent device with a metal layer having a metal microstructure.

It shall be understood by those skilled in the art that, while detailed description has been provided for preferred embodiments of the present invention, these should not be understood as limitations to the scope of the present invention, and the scope sought protection in the present invention should subject to the appended claims.

## Claims

1. A luminescent device, wherein the luminescent device comprises a luminescent substrate and a metal layer which is disposed on the surface of the luminescent substrate and has a metal microstructure which is composed of irregularly arranged metal nano-particles; and the material for the luminescent substrate is transparent ceramic having a formula of Y₂O₃:Eu.

2. The luminescent device according to claim 1, wherein the material for the metal layer is at least one selected from the group consisting of gold, silver, aluminum, copper, titanium, iron, nickel, cobalt, chromium, platinum, palladium, magnesium and zinc.

3. The luminescent device according to claim 1, wherein the thickness of the metal layer is in the range of 0.5 nm to 200 nm.

4. A method for manufacturing a luminescent device, comprising the steps of:
step S1: washing and drying a luminescent substrate, wherein the material for the luminescent substrate is transparent ceramic having a formula of Y₂O₃:Eu;
step S2: disposing a metal layer on a surface of the luminescent substrate;
step S3: annealing the luminescent substrate disposed with the metal layer in vacuum and then cooling, to produce a luminescent device having the metal layer with a metal microstructure which is composed of irregularly arranged metal nano-particles.

5. The method according to claim 4, wherein, in step S1, the washing process comprises washing the luminescent substrate sequentially with acetone, deionized water and absolute alcohol.

6. The method according to claim 5, wherein the drying process is carried out by oven-drying or blast-drying.

7. The method according to claim 4, wherein, in step S2, the material for the metal layer is at least one selected from the group consisting of gold, silver, aluminum, copper, titanium, iron, nickel, cobalt, chromium, platinum, palladium, magnesium and zinc.

8. The method according to claim 4, wherein, in step S2, the thickness of the metal layer is in the range of 0.5 nm to 200 nm.

9. The method according to claim 4, wherein, in step S3, the annealing process comprises annealing at 50°C to 650°C in vacuum for 0.5 to 5 hours and naturally cooling to room temperature.

## Patentansprüche

1. Lumineszenzvoruchtung, wobei die Lumineszenzvoruchtung ein Lumineszenzsubstrat und eine Metallschicht, die auf der Oberfläche des Lumineszenzsubstrats angeordnet ist und die eine Metallmikrostruktur aufweist, die aus unregelmäßig angeordneten Metallnanopartikeln besteht, umfasst; und wobei das Material für das Lumineszenzsubstrat eine durchsichtige Keramik mit einer Formel Y₂O₃:Eu ist.

2. Lumineszenzvoruchtung nach Anspruch 1, wobei das Material für die Metallschicht wenigstens eines ist, das aus der Gruppe ausgewählt ist, die aus Gold, Silber, Aluminium, Kupfer, Titan, Eisen, Nickel, Kobalt, Chrom, Platin, Palladium, Magnesium und Zink besteht.

3. Lumineszenzvoruchtung nach Anspruch 1, wobei die Dicke der Metallschicht in dem Bereich von 0,5 nm bis 200 nm liegt.

4. Verfahren zum Herstellen einer Lumineszenzvorrichtung, wobei das Verfahren die folgenden Schritte umfasst:
Schritt S1: Abspülen und Trocknen eines Lumineszenzsubstrats, wobei das Material für das Lumineszenzsubstrat eine durchsichtige Keramik mit einer Formel Y₂O₃:Eu ist;
Schritt S2: Anordnen einer Metallschicht auf einer Oberfläche des Lumineszenzsubstrats;
Schritt S3: Tempern des Lumineszenzsubstrats, das mit der Metallschicht in einem Unterdruck angeordnet ist, und daraufhin Abkühlen, um eine Lumineszenzvoruchtung zu erzeugen, die die Metallschicht mit einer Metallmikrostruktur aufweist, die aus unregelmäßig angeordneten Metallnanopartikeln besteht.

5. Verfahren nach Anspruch 4, wobei der Abspülprozess in Schritt S1 das aufeinanderfolgende Abspülen des Lumineszenzsubstrats mit Aceton, entionisiertem Wasser und reinem Alkohol umfasst.

6. Verfahren nach Anspruch 5, wobei der Trocknungsprozess durch Ofentrocknen oder Strahltrocknen ausgeführt wird.

7. Verfahren nach Anspruch 4, wobei das Material für die Metallschicht in Schritt S2 wenigstens eines ist, das aus der Gruppe ausgewählt ist, die aus Gold, Silber, Aluminium, Kupfer, Titan, Eisen, Nickel, Kobalt, Chrom, Platin, Palladium, Magnesium und Zink besteht.

8. Verfahren nach Anspruch 4, wobei die Dicke der Metallschicht in Schritt S2 in dem Bereich von 0,5 nm bis 200 nm liegt.

9. Verfahren nach Anspruch 4, wobei der Temperprozess in Schritt S3 das Tempern bei 50°C bis 650°C in Unterdruck für 0,5 bis 5 Stunden und das natürliche Abkühlen auf Raumtemperatur umfasst.

## Revendications

1. Dispositif luminescent, dans lequel le dispositif luminescent comprend un substrat luminescent et une couche métallique qui est disposée sur la surface du substrat luminescent et présente une microstructure métallique qui est composée de nanoparticules métalliques agencées de façon irrégulière ; et le matériau du substrat luminescent est de la céramique transparente ayant une formule de Y₂O₃:Eu.

2. Dispositif luminescent selon la revendication 1, dans lequel le matériau de la couche métallique est au moins un sélectionné parmi le groupe consistant en l'or, l'argent, l'aluminium, le cuivre, le titane, le fer, le nickel, le cobalt, le chrome, le platine, le palladium, le magnésium et le zinc.

3. Dispositif luminescent selon la revendication 1, dans lequel l'épaisseur de la couche métallique est située dans la plage de 0,5 nm à 200 nm.

4. Procédé de fabrication d'un dispositif luminescent, comprenant les étapes de :
étape S1 : lavage et séchage d'un substrat luminescent, dans lequel le matériau du substrat luminescent est de la céramique transparente ayant une formule de Y₂O₃:Eu ;
étape S2 : dépôt d'une couche métallique sur une surface du substrat luminescent ;
étape S3 : recuit du substrat luminescent disposé avec la couche métallique sous vide puis refroidissement, pour produire un dispositif luminescent présentant la couche métallique avec une microstructure métallique qui est composée de nanoparticules métalliques agencées de façon imégulière.

5. Procédé selon la revendication 4, dans lequel, à l'étape S1, le procédé de lavage comprend le lavage du substrat luminescent de façon séquentielle avec de l'acétone, de l'eau désionisée et de l'alcool absolu.

6. Procédé selon la revendication 5, dans lequel le procédé de séchage est effectué par séchage au four ou séchage par projection.

7. Procédé selon la revendication 4, dans lequel, à l'étape S2, le matériau de la couche métallique est au moins un sélectionné parmi le groupe consistant en l'or, l'argent, l'aluminium, le cuivre, le titane, le fer, le nickel, le cobalt, le chrome, le platine, le palladium, le magnésium et le zinc.

8. Procédé selon la revendication 4, dans lequel, à l'étape S2, l'épaisseur de la couche métallique est située dans la plage de 0,5 nm à 200 nm.

9. Procédé selon la revendication 4, dans lequel, à l'étape S3, le procédé de recuit comprend le recuit à 50°C à 650°C sous vide pendant 0,5 à 5 heures et le refroidissement naturel à température ambiante.
